Europäisches Patentamt

European Patent Office

Office européen des brevets

(11) Publication number: **0 216 403**
**A1**

## EUROPEAN PATENT APPLICATION

(21) Application number: 86201358.8

(51) Int. Cl.⁴: **G01R 31/26**

(22) Date of filing: 01.08.86

(30) Priority: 15.08.85 NL 8502252

(43) Date of publication of application:
01.04.87 Bulletin 87/14

(84) Designated Contracting States:
DE FR GB IT

(71) Applicant: N.V. Philips' Gloeilampenfabrieken
Groenewoudseweg 1
NL-5621 BA Eindhoven(NL)

(72) Inventor: Ruitenburg, Leonardus c/o INT.
OCTROOIBUREAU B.V.
Prof. Holstlaan 6
NL-5656 AA Eindhoven(NL)

(74) Representative: van Gils, Cornelis Johannes
Maria et al
INTERNATIONAAL OCTROOIBUREAU B.V.
Prof. Holstlaan 6
NL-5656 AA Eindhoven(NL)

(54) Variable capacitance diode tracking selection method and set of tracking-selected variable capacitance diodes.

(57) Variable capacitance diode tracking selection method and set of tracking-selected variable capacitance diodes.

Tracking selection of variable capacitance diodes is carried out by measuring the capacitances of the variable capacitance diodes at different operating voltages and by comparing the variable capacitance diodes on the basis of the capacitance variation at different operating voltages located relatively closely together.

EP 0 216 403 A1

## Variable capacitance diode tracking selection method and set of tracking-selected variable capacitance diodes.

The invention relates to a variable capacitance diode tracking selection method in which the capacitances of the variable capacitance diodes are measured at different operating voltages and in which a number of tracking tests with reference to a predetermined criterion is carried out with the aid of the capacitances measured.

Variable capacitance diodes, hereinafter briefly referred to as VC diodes, are particularly used as tuning capacitors in the RF and oscillator circuits of RF receivers such as TV and radio receivers. The capacitance of the VC diode and hence the tuning frequency of the relevant circuit is variable by means of a variable tuning voltage which is applied in the cut-off direction to the VC diodes of a number of resonant circuits. It is then important that the tuning frequency of all these resonant circuits varies within narrow limits to an equal extent with the variable tuning voltage.

A problem occurring is that it is found to be impossible to produce the requried VC diodes having sufficiently equal capacitance/voltage characteristics. This is solved in practice by measuring the capacitance/voltage characteristics of the VC diodes produced, selecting them on the basis of their capacitance/voltage characteristic and delivering VC diodes with substantially equal capacitance/voltage characteristic in the form of tracking-selected sets of, for example, 120 diodes to the producer of the receivers.

In the conventional method VC diodes are selected on the basis of the relative difference between the capacitances of the VC diodes at a number of operating voltages and when this difference for each of the operating voltages is less than, for example, 3 %, the relevant diodes are admitted to the same set. The selection mode will be described in greater detail in the course of this description. In this manner the user of the VC diodes can be given the guarantee that for each value of the operating (= tuning) voltage the capacitance of each diode of the set does not deviate by more than 3 % from that of any other diode of the same set.

It has, however, been found that in this conventional selection method there are still a number of diodes within a set which cause tracking problems between the tuning circuits of the receiver produced. It is of course possible to obviate these problems by using a more stringent selection criterion, for example, by only admitting a relative capacitance difference of 2 % between the VC diodes. Such a more stringent criterion implies, however, that the measuring and selection process has a much lower output and accordingly, a higher costprice of the products.

It is an object of the invention to obviate this drawback and to this end the method according to the invention is characterized in that each tracking test between the two variable capacitance diodes is carried out on the basis of their capacitance variation as a result of a relatively small variation of the operating voltage.

By using the capacitance variation as a result of a relatively small variation of the operating voltage for selection, it is achieved that the selection of the VC diodes is at least partially carried out on the basis of the mutual differences in the slopes of the capacitance/voltage characteristic curves of the VC diodes. Theinvention is based on the recognition that the capacitance variation differences (these are the differences in the slopes of the capacitance/voltage characteristic curves) of the VC diodes cause much greater tracking problems when using the VC diodes than the capacitance differences of these diodes themselves.

From the above it may be clear that the expression a relatively small variation of the operating voltage is to mean a variation of the operating voltage which is sufficiently small to obtain a reasonable approximation of the slope (derivative) of the capacitance/voltage characteristic curve.

It is to be noted that it is known from the magazine "Periodica Polytechnica", Vol. EL EIV, No. 3, 1970, pages 301-310 to measure the slope of the capacitance/voltage characteristic curve of a VC diode in order to be able to assess the usability of the VC diode as such. The result of this measurement is, however, not utilised for tracking selection of the VC diode with other VC diodes.

The method according to the invention is preferably characterized in that each said tracking test between two variable capacitance diodes is carried out on the basis of at least an approximation of the difference between the relative capacitance variation of one of the variable capacitance diodes at a relatively small variation of the operating voltage and the relative capacitance variation of the other variable capacitance diode at the same variation of the operating voltage so that the use of the VC diodes can be given the guarantee that the relative deviation in the slopes between every two diodes of a selected set remains below a predetermined percentage.

The method according to the invention does not essentially require more capacitance measurements than the method known so far, A preferred method in which the number of measurements does not essentially differ from the conventional method is characterized in that for a tracking test the capacitance of a variable capacitance diode is measured at an operating voltage and that the capacitance variation as a result of a relatively samll variation of the operating voltage is determined from the difference between this capacitance and the memorised capacitance which has been measured in a previous test at a contiguous operating voltage.

The invention also relates to a set of VC diodes selected in accordance with the method according to the invention.

The invention will now be further described with reference to the Figures shown in the drawing.

Figure 1 diagrammatically shows the flow chart of a selection process as used in the production of VC diodes.

Figure 2 shows diagrams to illustrate such a selection process and

Figures 3, 4 show some characteristic curves measured on a number of VC diodes.

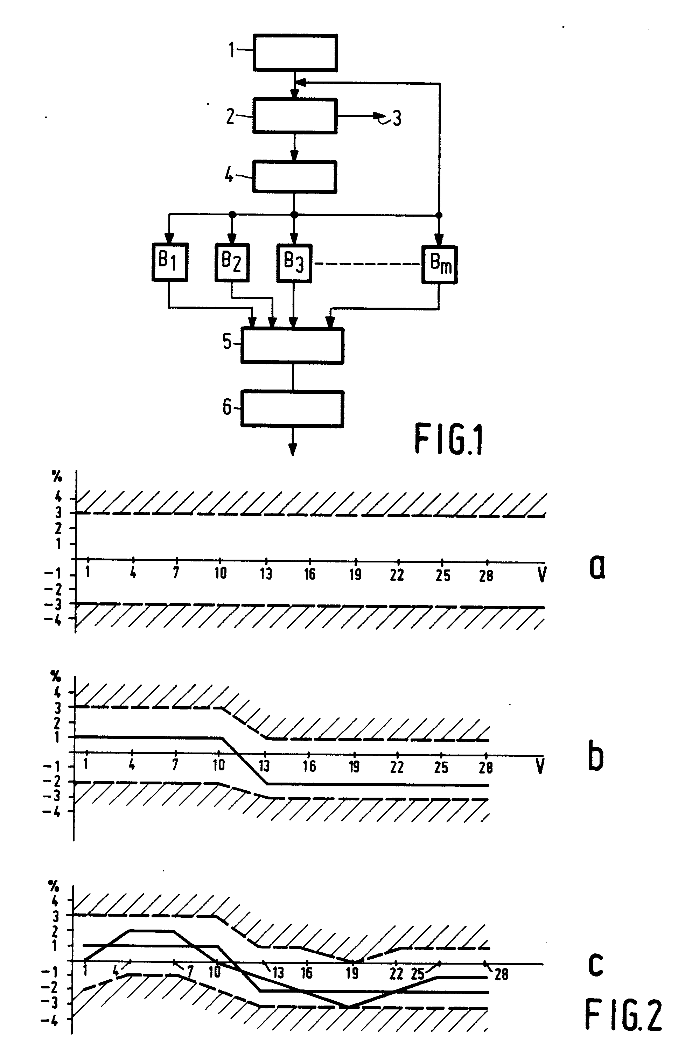

In Fig. 1 the reference numeral 1 diagrammatically shows the production phase of VC diodes. The VC diodes produced are checked in a checking phase 2 on important properties such as a sufficiently high zener voltage and a sufficiently low cut-off current and series resistance. Rejected specimens are removed at 3. A first selection may also be carried out on the basis of appropriate criteria, for example, the difference and/or the ratio between the capacitances at the low and the high end of the voltage range.

During phase 4 the actual tracking selection is carried out in the following manner.

1. The capacitance $C_{ref}(V)$ of a first VC diode is measured at a number of, for example, 10 different measuring voltages in steps of 3 volts within the total range of 0.5 to 28 volts. The measurement is preferably carried out by placing the VC diode in a measuring bridge which is fed, for example, with an alternating voltage of 1 MHz. It is of course also possible to measure the capacitance indirectly by placing the VC diode in a resonant circuit and by subsequently measuring its resonance frequency.

2. In the conventional selection method a maximum and a minimum limit value which is, for example 3 % above or 3 % below the measured capacitance $C_{ref}$ is determined for each measuring voltage. These limit values are stored in a memory for the ten measuring voltages and thus constitute a window within which a subsequent diode must have its measured values in order to be selected on the basis of tracking with the first diode. Such a window is shown in Fig. 2a. The first diode is subsequently deposited in the box B1.

3. A second diode is then measured at the same voltages. Each measured value is compared with the limit values determined for the first diode. When one of the measured values is outside the window of Fig. 2a, this second diode is not admitted to the box B1 but is deposited as a first diode in the box B2. When all measuring points are within the box determined for the first diode, the second diode is deposited in the box B1 and new limit values are determined for the B1 window (see Fig. 2b) such that all points within the new window do not deviate by more than 3% from the measured values of each of the two diodes in the box B1.

4. Each subsequent diode is measured in a corresponding manner and successively compared with the window of the boxes B1, B2 etc. until a box has been found within whose window the new diode fits. The diode is then admitted to this box and the window of this box adapted accordingly - (Fig. 2c). Dioded which are not admitted to any of the boxes B1 through Bm are returned to phase 2. The boxes B1 through Bm are filled up until they contain a given number of, for example, 120 diodes.

During phase 5 the set of VC diodes of each box is secured to a support, for example, an assembly belt. Preferably a plurality of sets is secured to one assembly belt and are mutually separated by a suitable marking. The final check is carried out in phase 6.

As described above the tracking selection phase 4 causes the relative capacitance deviation of each diode (C) of a selected set of diodes to deviate not more than 3 % from any arbitrary other diode ($C_{ref}$) of the set. In this case the selection criterion is thus $|\,S1\,| \leq 3$ %, in which the selection parameter is :

$$S1 = \frac{C - C_{ref}'}{C_{ref}}$$

According to the invention another selection parameter is used which is related to the extent of variation of the slopes of the capacitance/voltage characteristic curves of the VC diodes. According to the invention the selection parameter S2 is preferably chosen, for which it holds that

$$S2 = \cfrac{\dfrac{\Delta C}{C} - \dfrac{\Delta C_{ref}}{C_{ref}}}{\dfrac{\Delta C_{ref}}{C_{ref}}}$$

$\Delta C$ and $\Delta C_{ref}$ represent the capacitance variation of diodes $C$ and $C_{ref}$, respectively, between two measuring voltages located closely together. This method does not necessarily require the use of more measuring points than in the known method. It is sufficient to store the capacitance obtained at a given measuring voltage in a memory and to use this information for determining the selection magnitude associated with the subsequent measuring voltage.

The selection procedure may be carried out in a corresponding manner as described with reference to Figures 1 and 2. This means that of the first diode $C_{ref}$ the value of

$$\frac{\Delta C_{ref}}{C_{ref}}$$

for the various measuring voltages is determined and that for each of these voltages the upper and lower limits are determined from this value and are stored, in other words, a selection window is formed again. The value of $\dfrac{\Delta C}{C}$ for each measuring voltage is determined for each subsequent diode and compared with the upper and lower limits stored for this measuring voltage. If the measured value of $\dfrac{\Delta C}{C}$ for all measuring voltages is within the said limits, the relevant diode is admitted to the set and the new limits are fixed and stored.

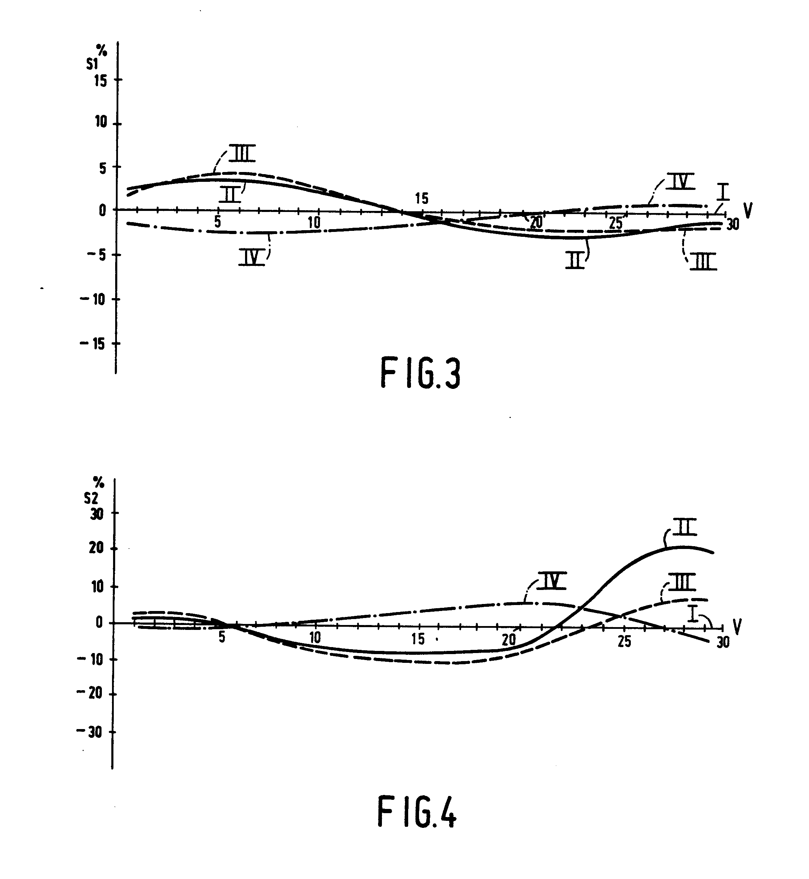

Fig. 3 shows the variation of the conventional selection parameter S1 as a function of the voltage for three diodes II,III and IV with respect to a diode I functioning as $C_{ref}$.

Fig. 4 shows the variation of the newly proposed selection parameter S2 as a function of the voltage for the same diodes. It can clearly be seen that the selection parameter S2 gives a completely different selection criterion. Where in the conventional method the diodes II and III would not be admitted to the same selection as diode I, based on their behaviour at the lower voltages, the behaviour at the higher voltages is rather more decisive in the proposed new selection method. It may be expected (this is still being researched) that much greater percentual deviations (up to ± 35 %) can be admitted with the selection parameter S2 than with the selection parameter S1 (± 3 %).

It is to be noted that the present invention is not limited to a strict use of the selection parameter S2 as defined above. Numerical approximations thereof may of course also be used without any objection.

$$\text{With } S1 = \frac{C - C_{ref}}{C_{ref}} \approx \frac{C - C_{ref}}{C} \text{ it can be}$$

$$\text{derived that}$$

$$S2 \approx S3 - S1(1 + S3) \text{ wherein } S3 = \frac{\Delta C - \Delta C_{ref}}{\Delta C_{ref}}$$

Since in practice S1 is considerably smaller than S2, $S2 \approx S3$ applies as an approximation. Therefore

$$S3 = \frac{\Delta C - \Delta C_{ref}}{\Delta C_{ref}}$$

can also be applied as selection parameter.

The capacitance of a VC diode may also be determined indirectly by combining the VC diode with a suitable inductance L to a resonant circuit whose resonance frequency

$$f = \frac{1}{2\pi\sqrt{LC}}$$

is then determined.

$$\text{With } f = \frac{1}{2\pi\sqrt{LC}} \quad \text{and} \quad f_{ref} = \frac{1}{2\pi\sqrt{LC_{ref}}}$$

it follows that the selection parameter S2 may also be approximated by

$$\frac{\dfrac{\Delta f}{f} - \dfrac{\Delta f_{ref}}{f_{ref}}}{\dfrac{\Delta f_{ref}}{f_{ref}}}$$

Since in practice $f \approx f_{ref}$ the selection parameter

$$\frac{\Delta f - \Delta f_{ref}}{\Delta f_{ref}}$$

is also usable as an approximation.

Further it is to be noted that in the case a quotient is proposed above whose numerator is the difference between two values and whose denominator is one of the two values, the denominator can be alternatively formed by the other of the two values or, for example, by the average of the two values.

Within the scope of the invention it is possible to vary the measuring voltages in steps which gradually increase or decease over the total measuring range. The admitted (percentual) deviation among the diodes themselves can also be varied over the measuring voltage range.

## Claims

1. A variable capacitance diode tracking selection method in which the capacitances of the variable capacitance diodes are measured at different operating voltages and in which a number of tracking tests based on a predetermined criterion is carried out with the aid of the measured capacitances, characterized in that each said tracking test between two variable capacitance diodes is carried out on the basis of their capacitance variation as a result of a relatively small variation of the operating voltage.

2. A method as claimed in Claim 1, characterized in that each said tracking test between two variable capacitance diodes is carried out on the basis of at least an approximation of the difference between the relative capacitance variation of one of the variable capacitance diodes at a relatively small variation of the operating voltage and the relative capacitance variation of the other variable capacitance diode at the same variation of the operating voltage.

3. A method as claimed in Claim 1 or 2, characterized in that for a tracking test the capacitance of thea variable capacitance diode is measured at an operating voltage and that the capacitance variation as a result of a relatively small variation of the operating voltage is determined from the difference between this capacitance and the memorised capacitance which has been measured in a previous test at a contiguous operating voltage.

4. A set of variable capacitance diodes selected by means of the method as claimed in one or more of the preceding Claims.

0 216 403

FIG.1

a

b

c

FIG.2

1-II- PHN 11463

FIG.3

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | WIRELESS WORLD, vol. 89, no. 1564, January 1983, pages 30,31,33, Sheepen Place, Olchester, GB; A. MACIEJEWSKI: "Matching tuning diodes" * Pages 30,31,33 * | 1 | G 01 R 31/26 |
| Y | PERIODICA POLYTECHNICA, vol. EL. XIV, no. 3, 1970, Budapest, HU; A. AMBROZY et al.: "Measuring instruments for hyperabrupt varactor tuning diodes" * Page 301, introduction; page 304, from the beginning of paragraph "Measurement of the dC/dU slope" - page 310, end of the article * | 1 | |
| A | Idem | 2 | **TECHNICAL FIELDS SEARCHED (Int. Cl.4)** |
| A | AUTOMATIK, vol. 15, no. 10, October 1970, pages 364-368, Bad Worishofen, DE; G. SCHADEBRODT et al.: "Automatische Einrichtung zur Gleichlaufsortierung von Kapazitätsdioden" | | G 01 R<br>H 03 J |
| A | GB-A-1 230 088 (PLESSEY CO. LTD) * Claims 1-4 * | 3 | |

The present search report has been drawn up for all claims

| Place of search | Date of completion of the search | Examiner |
|---|---|---|
| THE HAGUE | 27-11-1986 | KUSCHBERT D.E. |